# EUROPÄISCHE PATENTSCHRIFT

(11) **EP 2 064 748 B1**
(45) Veröffentlichungstag und Bekanntmachung des Hinweises auf die Patenterteilung: **20.09.2017**
(21) Anmeldenummer: 07818366.2
(22) Anmeldetag: 24.09.2007
(51) Int. Cl.: H01L 31/0224

(54) **VERFAHREN ZUR METALLISIERUNG VON HALBLEITERBAUELEMENTEN UND VERWENDUNG**
METHOD FOR METALLISING SEMICONDUCTOR ELEMENTS AND USE THEREOF
PROCÉDÉ DE MÉTALLISATION DE COMPOSANTS SEMI-CONDUCTEURS ET UTILISATION DE CE PROCÉDÉ

(30) Priorität: 22.09.2006 DE 102006044936
(43) Veröffentlichungstag der Anmeldung: 03.06.2009
(73) Patentinhaber: Fraunhofer-Gesellschaft zur Förderung der angewandten Forschung e.V., 80686 München (DE)
(72) Erfinder: GROHE, Andreas, 79108 Freiburg (DE); NEKARDA, Jan-Frederik, 79104 Freiburg (DE); SCHULTZ-WITTMANN, Oliver, 79102 Freiburg (DE)
(86) Internationale Anmeldenummer: PCT/EP2007/008279
(87) Internationale Veröffentlichungsnummer: WO 2008/034638

(56) Entgegenhaltungen:
- DE-A1- 10 020 412
- JP-A- 2003 246 971
- US-A- 4 393 576
- COTTER J E ET AL: "Novel processes for simplified buried contact solar cells", CONFERENCE RECORD OF THE 28TH IEEE PHOTOVOLTAIC SPECIALISTS CONFERENCE - 2000. (PVSC). ANCHORAGE, AK, SEPT. 15 - 22, 2000; [IEEE PHOTOVOLTAIC SPECIALISTS CONFERENCE], NEW YORK, NY : IEEE, US, vol. CONF. 28, 15 September 2000 (2000-09-15), pages 303-306, XP002200820, ISBN: 978-0-7803-5773-0

## Beschreibung

Vorliegende Erfindung betrifft ein Verfahren zur Metallisierung von Halbleiterbauelementen, bei denen Aluminium eingesetzt wird. Besonders bei Produkten, bei denen die Prozesskosten eine große Rolle spielen, wie z.B. Solarzellen auf Siliziumbasis, kann mit der Erfindung ein Kostenvorteil erreicht werden. Weiterhin betrifft vorliegende Erfindung die Verwendung des Verfahrens, beispielsweise bei der Herstellung von Solarzellen.

Bei den heutzutage größtenteils hergestellten kristallinen Solarzellen wird der Rückseitenkontakt durch das Einlegieren einer aluminiumhaltigen Siebdruckpaste in das Siliziummaterial erreicht. Hierbei wird die Paste kurz über ihren Schmelzpunkt erhitzt und bildet anschließend eine zusammenhängende Aluminiumschicht, welche die Querleitfähigkeit der Rückseitenmetallisierung sicherstellt. Darüber hinaus vermischt sich das Aluminium mit dem Silizium und bildet ein Eutektikum, welches die elektrischen Eigenschaften der Solarzellenrückseite verbessert.

Dieses Vorgehen bietet zwar eine gute elektrische Leitfähigkeit, jedoch sind die elektrischen und optischen Eigenschaften nur mäßig. Darüber hinaus stellt die thermische Belastung, welche beim Einlegieren der Paste benötigt wird eine Limitierung hinsichtlich der weiteren Optimierungsmöglichkeiten einer Solarzelle dar, da zum Beispiel nicht alle Folgeprozesse temperaturstabil sind.

Eine deutliche Verbesserung der optischen und elektrischen Eigenschaften kann erzielt werden, falls die Rückseite zuerst mit einer dielektrischen Schicht aus z.B. Siliziumoxid, Siliziumnitrid oder amorphem Silizium passiviert wird. Anschließend wird die Rückseite mit einer Aluminiumschicht metallisiert. Diese wird standardmäßig durch Vakuumverfahren wie z.B. Aufdampfen oder Sputtern aufgebracht.

Probleme entstehen bei diesen Verfahren vor allem durch das Vakuum, wobei hierunter Drücke von < 1 mbar zu verstehen sind. Die Erzeugung des Vakuums (d.h. das Abpumpen der Prozesskammer) verlängert die Prozesszeiten und führt zu hohen Kosten. Außerdem können bestimmte Stoffe, welche im Vakuum ausgasen würden, nicht im Vakuum beschichtet werden. Ein dritter Punkt ist die Unmöglichkeit, im Vakuum deponierte Schichten zielgenau an definierten Positionen abzuscheiden, d.h. es entsteht ein erhöhter Materialverbrauch sowie eine Verschmutzung der Prozesskammer, welche wiederum zu einer Verschlechterung der Qualität der beschichteten Bauelemente führen kann.

Bei der Verwendung einer dielektrischen Schicht kann die Aluminiumschicht anschließend über verschiedene Verfahren, unter anderem auch über ein LFC-Verfahren, mit dem Silizium kontaktiert werden. Dokument "Novel Processes for Simplified Buried Contact Solar Cells" von J.E. Cotter et al. IEEE 2000 (XP002200820) beschreibt ein Herstellungsverfahren für ein Rückseitenkontakt auf einer Solarzelle. Aufgabe der vorliegenden Erfindung ist es, ein kostengünstiges und schnelles Verfahren zur Beschichtung einer Oberfläche eines Halbleiters mit Aluminium bei niedrigen Prozesstemperaturen zu ermöglichen. Diese Aufgabe wird durch das Verfahren mit den Merkmalen des Patentanspruchs 1 gelöst. Mit Patentanspruch 18 wird eine erfindungsgemäße Verwendung des Verfahrens angegeben. Die jeweiligen abhängigen Ansprüche stellen dabei vorteilhafte Weiterbildungen dar.

Erfindungsgemäß wird ein Verfahren gemäß Anspruch 1 bereitgestellt, zur mindestens partiellen Metallisierung von mindestens einer Oberfläche von Halbleiterbauelementen mit Aluminium, wobei
a) eine Aluminiumfolie mindestens partiell in direkten Kontakt mit der Oberfläche gebracht, und
b) dass anschließend durch Energieeinwirkung ein mindestens partielles Verbinden des Aluminiums mit der Oberfläche des Halbleiterbauelementes durchgeführt wird.

Das Aufbringen der Aluminiumfolie (Schritt a)) erfolgt mit Hilfe geeigneter Methoden, wobei es wesentlich ist, dass die Folie partiell in direkten Kontakt mit dem Substrat gebracht wird. Dieser direkte Kontakt ist wichtig, da ansonsten nur eine Perforation der Folie ohne Befestigung am Substrat erzielt wird. Der direkte Kontakt kann dabei kraft- und/oder formschlüssig sein. Das Aufbringen der Aluminiumfolie (Schritt a) erfolgt durch Ansaugen auf die Oberfläche.

In einem alternativen günstigen Beispiel, nicht Teil der Erfindung, erfolgt das Aufbringen der Aluminiumfolie (Schritt a) über einen zwischen der Oberfläche und der Aluminiumfolie angeordneten Flüssigkeitsfilm. Erfindungsgemäß ist es dabei unerheblich, ob das Aufbringen des Flüssigkeitsfilms in dem Zustand erfolgt, in dem die Folie bereits auf die Oberfläche des zu beschichtenden Substrats aufgebracht ist oder ob vorher eine Benetzung des Substrats und/oder der Folie erfolgt und die Folie nach der Benetzung auf das Substrat aufgebracht wird. Als Flüssigkeitsfilm kann dabei ein Wasserfilm und/oder ein Lösungsmittelfilm eingesetzt werden.

Ein weiteres Beispiel des Verfahrens, nicht Teil der Erfindung, sieht vor, dass das Aufbringen der Aluminiumfolie (Schritt a) über eine zwischen der Oberfläche und der Aluminiumfolie angeordnete Opferschicht erfolgt. Vorzugsweise ist die Opferschicht dabei ausgewählt aus der Gruppe bestehend aus amorphem Silizium, dielektrischen Schichten, Metallschichten, Schichten aus organischen Stoffen und/oder Folien aus diesen Stoffen. Die dabei verwendete Opferschicht löst sich im Verfahrensschritt b vollständig in der Aluminiumfolie auf. Am Beispiel des amorphen Siliziums erfolgt die vollständige Auflösung im Aluminium bei Temperaturen von ca. 400 °C und darüber. Die Opferschicht kann sich, analog dem Flüssigkeitsfilm, bereits auf der Oberfläche der Aluminiumfolie oder des Bauelements befinden.

Durch das erfindungsgemäße Verfahren ist es prinzipiell möglich, Aluminiumfolien einer beliebigen Schichtdicke auf eine Halbleiteroberfläche aufzubringen, bevorzugt sind jedoch Dicken von 1 µm bis 20 µm.Die Aluminiumfolie weist eine größere Abmessung auf, als die zu metallisierende Oberfläche des Halbleiterbauelements. Die Aluminiumfolie weist zusätzliche metallische Strukturen auf. Beispielsweise kann anstatt einer homogenen Aluminiumfolie eine Folie verwendet werden, welche zusätzlich dünne Streifen Metall zur Verschaltung der einzelnen Halbleiterbauelemente untereinander enthält. Diese Streifen werden gleichzeitig mit der Folie befestigt und können über den die Begrenzung des Halbleiterelements bildenden Rand hinausreichen, um dann mit anderen Halbleiterbauelementen verbunden zu werden. Alternativ hierzu können auch dem Fachmann bekannte, standardisierte Mittel zur elektrischen Verschaltung der einzelnen Bauelemente vor dem Prozess unter die Aluminiumfolie gelegt werden, welche dann im Verfahrensschritt b) auf dem Substrat gleichzeitig sowohl am Substrat und der Folie befestigt werden können.

Das gemäß Merkmal b) vorgesehene Verbinden der Aluminiumfolie erfolgt zumindest in dem Bereich, in dem sich die Aluminiumfolie in direktem Kontakt mit der Oberfläche befindet.

Eine effiziente sowohl teilweise als auch ganzflächige Verbindung der Aluminiumfolie mit der Oberfläche (Verfahrensschritt b) kann vorteilhafterweise durch Lasereinwirkung erfolgen. Somit wird auf eine einfache Weise eine gut haftende Verbindung ermöglicht. Die Laserstrahlung wird dabei von oben auf die Folie geführt und erhitzt diese kurzzeitig so stark, dass eine lokale Verschmelzung entweder mit dem Substrat oder einer dazwischenliegenden Opferschicht hervorgerufen wird. Der Laser kann ebenso vorgegebene Strukturen, wie z.B. Muster auf der Folie abfahren: Hierbei können sowohl Streifen als auch punktförmige Strukturen erzeugt werden. Der Laser unterliegt dabei keiner besonderen Beschränkung, maßgeblich ist, dass der Laser Strahlung einer Wellenlänge und mit einer solchen Intensität abgibt, dass ein zumindest teilweises Aufschmelzen der Folie gewährleistet ist. Insbesondere kann dabei ein Infrarotlaser eingesetzt werden. Jedoch ist eine erfindungsgemäße Energieeinwirkung nicht ausschließlich auf ein Laserverfahren beschränkt, sondern jede andere geeignete Ausführungsform, die den gewünschten Effekt mit sich bringt, ist ebenfalls geeignet. Beispielsweise könnte auch eine Bestrahlung der Aluminiumfolie mit hinreichend intensiver, nicht kohärenter infraroter Strahlung erfolgen.

Insbesondere eignet sich das Verfahren, wenn als Halbleiterbauelement eine Solarzelle eingesetzt wird. Dabei ist es bevorzugt, wenn die Metallisierung als Rückseitenkontakt auf die Solarzelle aufgebracht wird.

Hierzu, nicht erfindungsgemäß, wird die Aluminiumfolie mit Hilfe geeigneter Methoden in direkten Kontakt mit dem Substrat gebracht. Dieser direkte Kontakt ist wichtig, da ansonsten nur eine Perforation der Folie ohne Befestigung am Substrat erzielt wird. Geeignete Methoden für die direkte Kontaktierung sind zum Beispiel mechanisches Andrücken, Anblasen und/oder Ansaugen. Weiterhin kann die Folie am Substrat befestigt werden, indem zwischen das Substrat und die Folie einige Tropfen einer Flüssigkeit gegeben werden und diese annähernd vollständig ausgestrichen wird. Eine dritte Möglichkeit wäre, eine zusätzliche Opferschicht zu benutzen, welche sich bei einem nach dem Aufbringen der Alufolie anschließenden zusätzlichen Prozessschritt auflöst. Dazu wird amorphes Silizium benutzt, welches sich bei Temperaturanwendung über 400 °C vollständig im Aluminium auflöst.

Bei den bisher durchgeführten Versuchen wurde die Aluminiumfolie mit Hilfe einer Vakuumansaugung auf den Proben befestigt. Hierzu wurde die Folie über den Rand lappend auf die Probe gelegt und sowohl Probe als auch Folie mit einer Vakuumvorrichtung auf dem Bearbeitungstisch festgesaugt. Dieses Vorgehen führt dazu, dass die zwischenliegende Luft vollständig entfernt wird und die Folie ganzflächig auf der Probe aufliegt.

Als abschließenden Schritt wird die Aluminiumfolie mit Hilfe von Laserstrahlung mit dem Substrat auf eine solche Weise verbunden, dass eine gut haftende Verbindung entsteht. Diese Laserstrahlung wird von oben auf die Folie geführt und erhitzt diese kurzzeitig so stark, dass eine lokale Verschmelzung entweder mit dem Substrat oder einer dazwischenliegenden Opferschicht hervorgerufen wird. Der Laser kann verschiedene Muster auf der Folie abfahren: entweder wird die Folie ganzflächig bearbeitet oder aber nur partiell. Hierbei können sowohl streifen- als auch punktförmige Strukturen erzeugt werden.

Für eine Positionierung der Folie relativ zum Substrat bieten sich mehrere Möglichkeiten an. Einerseits kann die Folie in einer dem Substrat entsprechenden Größe positionsgenau auf das Substrat gelegt werden. Somit kann die komplette Fläche sowie Bruchstücke der Fläche metallisiert werden. Eine andere Möglichkeit ist, Folie mit deutlich größerer Fläche als das Substrat über den Substratrand hinaus aufzulegen. Auch hier ist sowohl eine komplette Befestigung der Folie am Substrat als auch nur eine partielle Befestigung möglich. In einem abschließenden Laserschritt kann die Folie dann mit modifizierten Laserparametern entweder auf die Substratgröße oder aber eine beliebige Form heruntergeschnitten werden. Dabei kann durch den Laserschnitt einerseits ein gut haftender Abschluss der Folie mit dem Substratrand erzielt werden, andererseits die über den Substratrand hinausstehenden Folie abgeschnitten werden. Diese Folienreste können dann abgenommen werden.

### Beispiel

### (nicht Teil der Erfindung)

Eine im Vorausstehenden beschriebene Solarzelle mit einer Größe von 20x20 mm² ohne Vorderseitentextur auf Float Zone Silizium wird zur Messung der Hellkennlinie an einem Strom-Spannungs-Messplatz vermessen. Die Struktur der Solarzelle besteht aus 250 µm dicken Siliziumwafern, welche auf der Vorderseite mit einer Emitterschicht (zur Herstellung des p-n-Übergangs der Solarzelle), einer Antireflexbeschichtung und einer Vorderseitenmetallisierung versehen ist. Derartige Strukturen werden auch als High-Efficiency-Strukturen bezeichnet, weil diese bei geeignetem Material und Prozessführung hohe Wirkungsgrade ermöglichen. Bei diesen Strukturen sind die möglichen Verlustkanäle so weit wie möglich unterdrückt, um störende Einflüsse zu eliminieren und dadurch die beim Experiment verwendeten Variationen deutlicher unterscheiden zu können. Auf der Rückseite ist eine dielektrische Beschichtung aufgebracht, über die handelsübliche Aluminiumfolie (z.B. aus dem Supermarkt, Dicke ca. 14 µm) aufgebracht wird. Dabei wird die Aluminiumfolie mit Hilfe einer Ansaugvorrichtung auf der Rückseite fixiert und mit punktueller Laserbestrahlung befestigt. Es wurden die in folgender Tabelle angegebenen, die Qualität einer Solarzelle beschreibenden Parameter ermittelt.

| **V_{oc}** | **J_{sc}** | **FF** | **η** |
|---|---|---|---|
| **[mV]** | **[mA/cm²]** | | **[%]** |
| 661,7 | 33,68 | 0,784 | 17,5 |

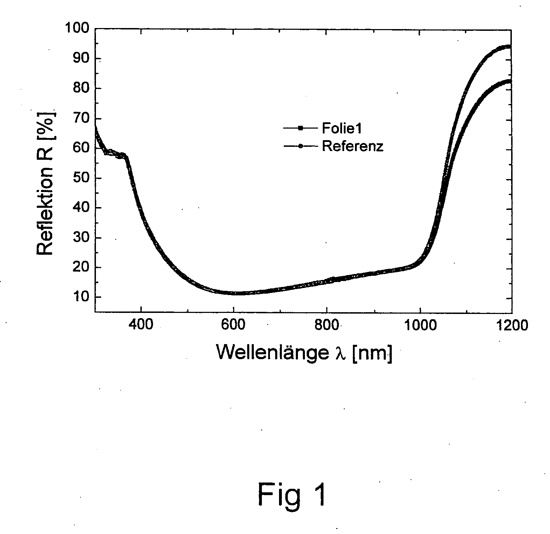

In Figur 1 ist eine Reflexionskurve dieser erfindungsgemäß metallisierten Solarzelle, die an einem Reflektionsmessplatz ermittelt wird, dargestellt. Dabei wird die Probe beleuchtet und mit Hilfe einer Ulbrichtkugel der reflektierte Anteil in Abhängigkeit von der Wellenlänge gemessen. Im Vergleich zu einer Referenzsolarzelle (d.h. eine Solarzelle, die nicht nach dem erfindungsgemäßen Verfahren hergestellt wurde) ist eine beinahe gleich gute Reflektion der Rückseite im Wellenlängenbereich > 1000 nm zu sehen. Diese Wellenlängenbereiche sind jedoch für die Auslösung von Elektronen kaum geeignet, da hier die Absorptionslänge des Siliziums kleiner als die Solarzellendicke wird. Für die zur Stromerzeugung relevanten Wellenlängenbereiche (also < 1000 nm) ist zwischen der Referenzsolarzelle und der erfindungsgemäß beschichteten Solarzelle kein Unterschied im Reflektionsgrad zu erkennen. Somit wird bei deutlich vereinfachter Verfahrensführung eine Rückseitenbeschichtung mit quasi äquivalentem Reflexionsgrad bereitgestellt.

## Patentansprüche

1. Verfahren zur mindestens partiellen Metallisierung von mindestens einer Oberfläche von Halbleiterbauelementen mit Aluminium,
**dadurch gekennzeichnet, dass**
a) eine Aluminiumfolie durch ansaugen der Aluminiumfolie an die Oberfläche mindestens partiell in direkten Kontakt mit der Oberfläche gebracht,
wobei die Aluminiumfolie eine größere Abmessung aufweist als die zu metallisierende Oberfläche und die Folie über den Rand des Halbleiterbauelements lappend auf die Oberfläche gelegt und sowohl das Halbleiterbauelement als auch die Folie mit einer Vakuumvorrichtung auf einem Bearbeitungstisch festgesaugt wird, und
wobei die Aluminiumfolie zusätzliche metallische Strukturen aufweist und die metallischen Strukturen so ausgebildet werden, dass sie zur Verschaltung mit weiteren Halbleiterbauelementen eingesetzt werden können, und
b) dass anschließend durch Energieeinwirkung ein mindestens partielles Verbinden des Aluminiums mit der Oberfläche des Halbleiterbauelementes durchgeführt wird.

2. Verfahren nach dem vorhergehenden Anspruch, **dadurch gekennzeichnet, dass** die Aluminiumfolie eine Dicke von 1 µm bis 20 µm aufweist.

3. Verfahren nach einem der vorhergehenden Ansprüche,
**dadurch gekennzeichnet, dass** die zusätzlichen Strukturen in Form von metallischen Streifen in der Aluminiumfolie ausgebildet sind.

4. Verfahren nach einem der vorhergehenden Ansprüche,
**dadurch gekennzeichnet, dass** das mindestens partielle Verbinden der Aluminiumfolie mit der Oberfläche (Verfahrensschritt b)) durch Lasereinwirkung erfolgt.

5. Verfahren nach dem vorhergehenden Anspruch, **dadurch gekennzeichnet, dass** der Laser vorgegebene Strukturen abfährt.

6. Verfahren nach Anspruch 4 oder 5,
**dadurch gekennzeichnet, dass** mittels des Lasers Streifen und/oder punktförmige Strukturen erzeugt werden.

7. Verfahren nach einem der vorhergehenden Ansprüche,
**dadurch gekennzeichnet, dass** als Halbleiterbauelement eine Solarzelle eingesetzt wird.

8. Verfahren nach dem vorhergenden Anspruch,
**dadurch gekennzeichnet, dass** die Metallisierung als Rückseitenkontakt auf der Solarzelle ausgeführt wird.

9. Verwendung des Verfahrens nach einem der vorhergehenden Ansprüche zur Metallisierung von Solarzellen.

10. Verwendung nach dem vorhergehenden Anspruch als Rückseitenkontakt auf der Solarzelle.

## Claims

1. A method for the at least partial metallisation of at least one surface of semiconductor components with aluminium,
**characterised in that**
a) an aluminium foil is brought at least partially into direct contact with the surface by suction of the aluminium foil onto the surface,
the aluminium foil having a larger dimension than the surface to be metallised, and the foil being laid on the surface lapping over the edge of the semiconductor component, and both the semiconductor component and the foil being attached by suction to a machining bench with a vacuum device, and
the aluminium foil having additional metallic structures and the metallic structures being configured such that they can be used for interconnecting with further semiconductor components, and
b) **in that** at least partial connection of the aluminium to the surface of the semiconductor component is subsequently carried out by the action of energy.

2. A method according to the preceding claim,
**characterised in that** the aluminium foil has a thickness of 1 µm to 20 µm.

3. A method according to one of the preceding claims,
**characterised in that** the additional structures are designed in the form of metallic strips in the aluminium foil.

4. A method according to one of the preceding claims,
**characterised in that** the at least partial connection of the aluminium foil to the surface (method step b)) takes place by the action of a laser.

5. A method according to the preceding claim,
**characterised in that** the laser travels over specified structures.

6. A method according to Claim 4 or 5,
**characterised in that** strips and/or punctiform structures are produced by means of the laser.

7. A method according to one of the preceding claims,
**characterised in that** a solar cell is used as a semiconductor component.

8. A method according to the preceding claim,
**characterised in that** the metallisation is embodied as a back contact on the solar cell.

9. Use of the method according to one of the preceding claims for the metallisation of solar cells.

10. Use according to the preceding claim as a back contact on the solar cell.

## Revendications

1. Procédé de métallisation au moins partielle d'au moins une surface d'éléments à semi-conducteurs avec de l'aluminium, **caractérisé en ce que**
a) une feuille d'aluminium est mise en contact au moins partiellement direct avec la surface par aspiration de la feuille d'aluminium contre la surface,
la feuille d'aluminium présentant des dimensions supérieures à celles de la surface à métalliser et la feuille étant posée sur le bord de l'élément à semi-conducteurs à cheval sur la surface et l'élément à semi-conducteurs ainsi que la feuille étant aspirées avec un dispositif de vide sur une table de traitement, et
la feuille d'aluminium comprenant des structures métalliques supplémentaires et les structures métalliques étant conçues de façon à ce qu'elles puissent être utilisées pour le branchement avec d'autres éléments à semi-conducteurs et
b) ensuite, par un apport d'énergie, une liaison au moins partielle de l'aluminium avec la surface de l'élément à semi-conducteurs est effectuée.

2. Procédé selon la revendication précédente, **caractérisé en ce que** la feuille d'aluminium présente une épaisseur de 1 µm à 20 µm.

3. Procédé selon l'une des revendications précédentes, **caractérisé en ce que** les structures supplémentaires sont conçues sous la forme de bandes métalliques dans la feuille d'aluminium.

4. Procédé selon l'une des revendications précédentes, **caractérisé en ce que** la liaison au moins partielle de la feuille d'aluminium avec la surface (étape de procédé b) a lieu par laser.

5. Procédé selon la revendication précédente, **caractérisé en ce que** le laser produit des structures prédéterminées.

6. Procédé selon la revendication 4 ou 5, **caractérisé en ce que** le laser permet de produire des bandes et/ou des structures ponctuelles.

7. Procédé selon l'une des revendications précédentes, **caractérisé en ce qu'**une cellule photovoltaïque est utilisée en tant qu'élément à semi-conducteurs.

8. Procédé selon la revendication précédente, **caractérisé en ce que** la métallisation est effectuée en tant que contact arrière sur la cellule photovoltaïque.

9. Utilisation du procédé selon l'une des revendications précédentes pour la métallisation de cellules photovoltaïques.

10. Utilisation selon la revendication précédente en tant que contact arrière sur la cellule photovoltaïque.
